Europäisches Patentamt

European Patent Office

Office européen des brevets

(11) Publication number: **0 274 850 B1**

## EUROPEAN PATENT SPECIFICATION

(45) Date of publication of patent specification: **08.04.92**

(51) Int. Cl.5: **H03H 21/00**, H04B 3/23

(21) Application number: **87310605.8**

(22) Date of filing: **02.12.87**

(54) Adaptive digital filters and echo cancelers.

(30) Priority: **07.01.87 JP 542/87**
**07.01.87 JP 543/87**
**07.01.87 JP 544/87**

(43) Date of publication of application:
**20.07.88 Bulletin 88/29**

(45) Publication of the grant of the patent:
**08.04.92 Bulletin 92/15**

(84) Designated Contracting States:
**DE FR GB**

(56) References cited:

**PATENT ABSTRACTS OF JAPAN, vol. 8, no. 272 (E-284)[1709], 13th December 1984; & JP-A-59 141 814 (OKI DENKI KOGYO K.K.) 14-08-1984**

**PATENT ABSTRACTS OF JAPAN, vol. 8, no. 53 (E-231)[1490], 9th March 1984; & JP-A-58 206 223 (ENUEFU KAIRO SETSUKEI BUROT-SUKU K.K.) 01-12-1983**

**IEEE CIRCUITS AND SYSTEMS MAGAZINE, vol. 4, no. 1, March 1982, pages 4-10, IEEE, New York, US; F.J. TAYLOR et al.: "Computer aided design and analysis of standard IIR**

architectures - Part II"

(73) Proprietor: **Oki Electric Industry Company, Limited**
**7-12, Toranomon 1-chome Minato-ku**
**Tokyo 105(JP)**

(72) Inventor: **Kobayashi, Masaki**
**Oki Electric Ind. Co. Ltd. 7-12 Toranomon 1-ch.**
**Minatoku Tokyo(JP)**

(74) Representative: **SERJEANTS**
**25, The Crescent King Street**
**Leicester, LE1 6RX(GB)**

EP 0 274 850 B1

**Description**

**Technical Field**

This invention relates to adaptive digital filters capable of generating an arbitrary transfer function having a fast rate of convergence, suitable for use in an echo canceler.

**Background Art**

Recent rapid progress in digital signal-processing technology has created great interest in adaptive digital filters due to their wide range of applications. Typical of these applications in system identification, which is a process of estimating an unknown system characteristic from input and output data.

Such a system is described in the Applicants EP-A-87306101.4. The adaptive digital filter disclosed therein displays excellent convergence characteristics when the input signal is a white-noise signal. When the input signal has a non-white characteristic, as in a voice signal, the outputs from each section of the filter are not orthogonal, and their mean square values are unequal, so the convergence characteristics of the variable coefficients are degraded.

The Invention

The invention provides an adaptive digital filter comprising M basic sections (wherein M is a positive integer) each having a second-order recursive filter with scaler coefficients $a_m$ and $b_m$, a first coefficient scaler for multiplying a first one of a zeroth-order delayed output and a first-order delayed output from the second-order recursive filter by a first coefficient, a first variable-coefficient scaler for multiplying the first one of the zeroth-order delayed output and the first-order delayed output from the second-order recursive filter by a first variable-coefficient, a first adder for adding the output from the first scaler and a second one of the zeroth-order delayed output and the first-order delayed output from the second-order recursive filter, a second variable-co-efficient scaler for multiplying the output from the first adder by a second variable-coefficient, and a second adder for adding the outputs from each of the variable-coefficient scalers, characterised in that the scaler coefficients $a_m$ and $b_m$ are selected such that the poles of the second order recursive filter are located near the unit circle in the Z plane, and the first variable coefficient and the second variable coefficient are selected such that the mean square values of the first one of the zeroth-order delayed output and the first-order delayed output from the second-order recursive filter and the output from the first adder are equal.

In a preferred arrangement the first one of the outputs from the second-order recursive filter is a first-order delayed output and the second one of the outputs from the second-order recursive filter is a zeroth-order delayed output. In another the first one of the outputs from the second-order recursive filter is a zeroth-order delayed output and the second one of the outputs from the second-order recursive filter is a first-order delayed output.

The M basic sections are preferably connected in series. M-1 of the M basic sections may have a second-order non-recursive filter, the output of which is conencted to the second-order recursive filter of the next section. Alternatively the M basic sections may be connected in parallel. The outputs from the second adder of each section may be added to produce the final output from the filter.

**Drawings:**

Figure 1 is a schematic diagram showing in principle the identification of an unknown system by use of an adaptive digital filter;
Figure 2 is a schematic diagram showing a teleconferencing system employing an echo canceler comprising an adaptive digital filter as in Figure 1;
Figure 3 shows a configuration of an adaptive digital filter as in our EP Application mentioned above;
Figure 4 shows the adaptive digital filter of Figure 3 without scalers to explain the selection of coefficients $a_m$ and $b_m$;
Figure 5 shows the m-th basic section in Figure 3 to explain equalization of mean square values of $g_m(k)$ and $V_m(k)$;
Figure 6 shows in combination the configuration of Figures 4 and 5;
Figures 7 to 10 show adaptive digital filters of different embodiments of the invention; and
Figures 11 and 12 show echo cancelers of further embodiments of the invention.

## Best Mode

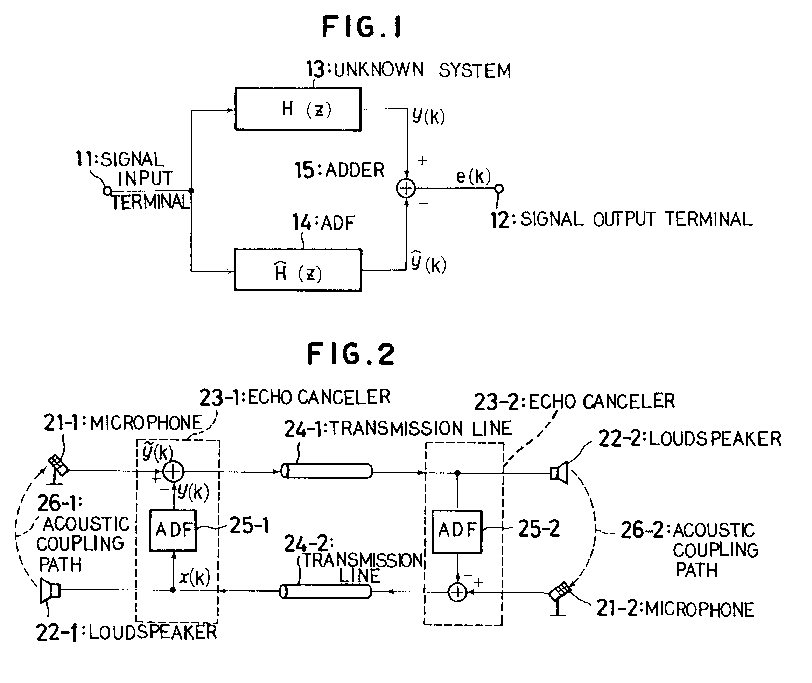

With particular reference to Figure 1, identification means comprise a signal input terminal 11, an error output terminal 12, an unknown system 13, and adaptive digital filter (ADF) 14, and an adder 15. In the figure $x(k)$ is the input to the unknown system 13 and the adaptive digital filter 14 at time $k$, $y(k)$ is the output from the unknown system 13 at time $k$, $\hat{y}(k)$ is the output from the adaptive digital filter 14 at time $k$, $e(k)$ is the estimation error at time $k$, $H(z)$ is the transfer function of the unknown system, and $\hat{H}(Z)$ is the transfer function of the adaptive digital filter 14. In the configuration shown, if the evaluation function is $J = e(k)^2$, then when $J = O$ the adaptive digital filter 14 is regarded as correctly estimating the characteristic of the unknown system 13.

Figure 2 is a schematic diagram of a teleconferencing system employing an echo canceler. This system comprises a pair of microphones 21-1 and 21-2, a pair of loudspeakers 22-1 and 22-2, a pair of echo cancelers 23-1 and 23-2, a pair of transmission lines 24-1 and 24-2, and a pair of adaptive digital filters 25-1 and 25-2, and includes a pair of acoustically coupled paths 26-1 and 26-2. In most teleconferencing systems the loudspeaker and microphone shown in Figure 2 are integrated into a single unit called a voice terminal. This gives rise to an acoustic coupling between the loudspeaker and the microphone: the signal output from the loudspeaker is coupled into the microphone and greatly degrades the quality of the voice transmission. In Figure 2 there are acoustic coupling paths, labelled 26-1 and 26-2, between the loudspeaker 22-1 and the microphone 21-1, and between the loudspeaker 22-2 and the microphone 21-2, but the echo cancelers 23-1 and 23-2 act to eliminate the signal coupled from the loudspeaker into the microphone.

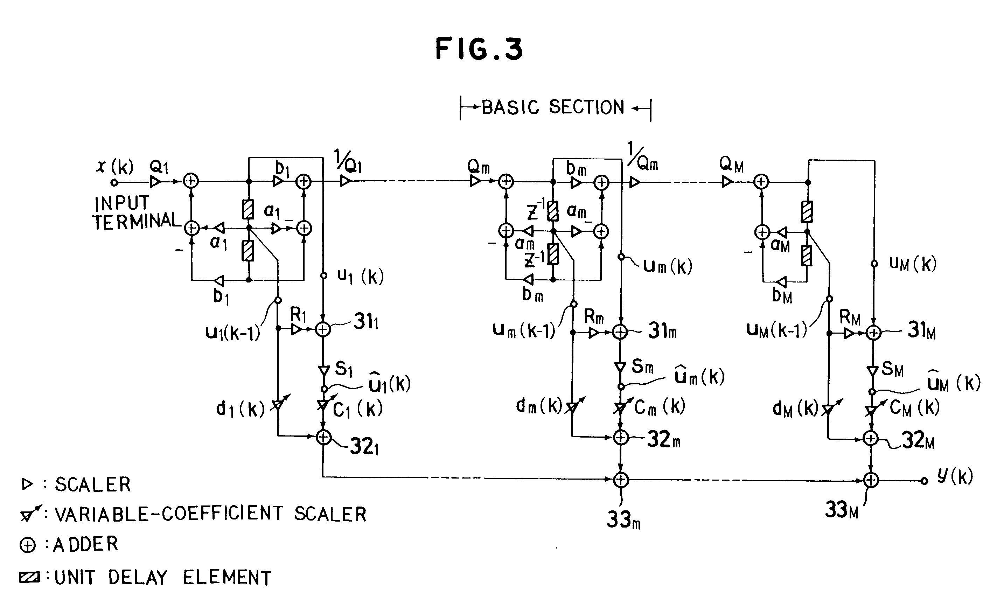

Our EP Application EP-A-87306101.4 mentioned above shows in Figure 3 hereto the first of these adaptive digital filters. This adaptive digital filter comprises M basic sections connected in series (where M is a positive integer). Basic sections 1 through M-1 each comprise a second-order recursive digital filter and a second-order non-recursive digital filter. Basic section M, the final section, comprises a second-order recursive digital filter. Adjacent basic sections are connected by scalers that multiply by $Q_m$ and by $1/Q_m$ ($m = 1$ to $M$). Each basic section also has a first-order non-recursive digital filter comprising a scaler $R_m$ for multiplying the first-order delayed output $u_m(k-1)$ by the coefficient $R_m$, an adder 31 for adding the result to the Oth-order delayed output $u_m(k)$, a scaler $S_m$ for multiplying the output of the adder $31_m$ by the coefficient $S_m$, a variable-coefficient scaler $C_m(k)$ for multiplying the result $u_m(k)$ by a variable coefficent $c_m(k)$, a variable-coefficient scaler $d_m(k)$ for multiplying the first-order delayed output $u_m(k-1)$ by a variable coefficient $d_m(k)$, and an adder $32_m$ for adding the outputs of the two variable-coefficient scalers $c_m(k)$ and $d_m(k)$. The outputs from the adders $32_m$ are added one after the other and the output from the adder $33_M$ is the output $y(k)$ of the filter with respect to the input $x(k)$.

The coefficients $Q_m$ of the scalers $Q_m$ ($m = 1$ to $M$) are chosen so that the mean square values of the first order delayed outputs $u_m(k-1)$ ($m = 1$ to $M$) are equal to the mean square value of the input signal $x(k)$ (a white-noise signal). The coefficients $S_m$ of the scalers $S_m$ ($m = 1$ to $M$) are chosen so that the mean square values of their outputs $\hat{u}_m(k)$ ($m = 1$ to $M$) are equal to the mean square value of the input signal $x(k)$. The coefficients $R_m$ of the scalers $R_m$ ($m = 1$ to $M$) are chosen so that when $x(k)$ is a white-noise signal, the signals $\hat{u}_m(k-1)$ and $\hat{u}_m(k)$ ($m = 1$ to $M$) are orthogonal. These selections increase the rate of convergence of the variable coefficients $c_m(k)$ and $d_m(k)$ (also called the adaptive parameters) of the variable-coefficient scalers.

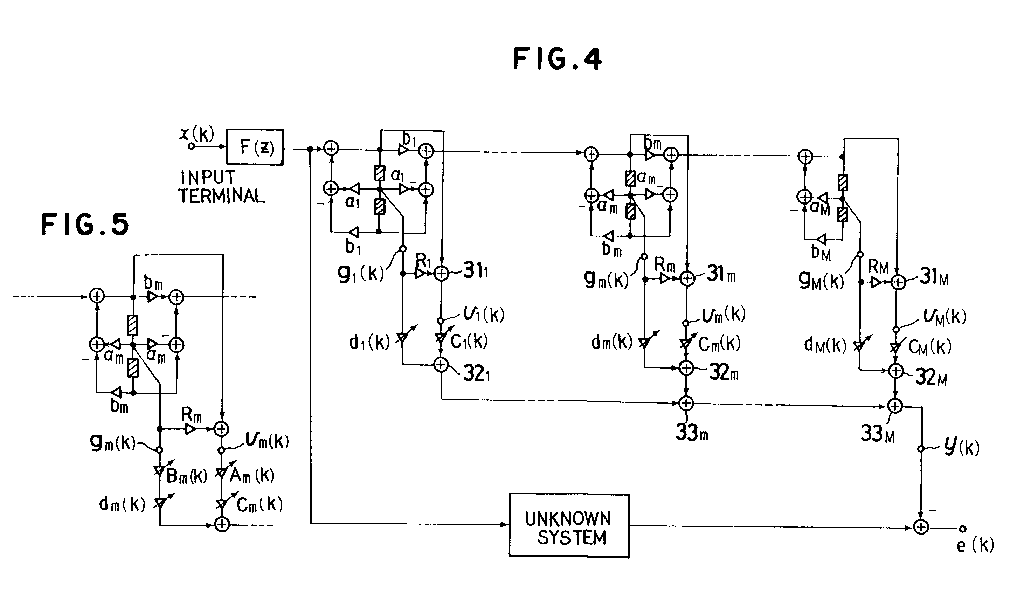

Figure 4 shows the adaptive digital filter of Figure 3 the scaler $Q_m$ having the coeffecent $Q_m$ ($m = 1$ to $M$), the scaler $1/Q_m$ having the coefficient $1/Q_m$ ($m = 1$ to $M$), and the scaler $S_m$ having the coefficient $S_m$. Assume that the input signal $x(k)$ has a white characteristic, and that a circuit with a transfer function $F(z)$ converts this to a signal with a non-white characteristic, which is input to the adaptive digital filter. Let $g_m(k)$ be the output of the first-order delay element in the m-th basic section ($m = 1$ to $M$), let $v_m(k)$ be the sum of $g_m(k)$ multiplied by the coefficient $R_m$ ($m = 1$ to $M$) and the 0th-order delayed output, and let $g_m(z)$ and $v_m(z)$ be the z-transforms of $g_m(k)$ and $v_m(k)$. Then:

$$G_m(z) = \frac{\displaystyle\prod_{i=1}^{m-1}(b_i - a_i z^{-1} + z^{-2}) \cdot z^{-1}}{\displaystyle\prod_{i=1}^{m}(1 - a_i z^{-1} + b_i z^{-2})}$$

$$V_n(z) = \frac{(1 + R_n z^{-1})\displaystyle\prod_{i=1}^{n-1}(b_i - a_i z^{-1} + z^{-2})}{\displaystyle\prod_{i=1}^{n}(1 - a_i z^{-1} + b_i z^{-2})} \qquad\qquad (1)$$

The time average of $g_m(k)$ and $v_m(k)$ is calculated as follows, where $E[.]$ is the time-averaging operator:

$$E[g_m(k) \cdot v_n(k)]$$

$$= \frac{1}{2\pi j}\oint G_m(z) \cdot v_n(z^{-1}) \cdot |F(z)|^2 z^{-1} dz$$

$$= \frac{1}{2\pi j}\oint \frac{z^{-1}\displaystyle\prod_{i=1}^{m-1}(b_i - a_i z^{-1} + z^{-2})}{\displaystyle\prod_{i=1}^{m}(1 - a_i z^{-1} + b_i z^{-2})}$$

4

$$\cdot \ \frac{(1+R_n z) \prod\limits_{i=1}^{n-1} (b_i - a_i z + z^2)}{\prod\limits_{i=1}^{n} (1 - a_i z + b_i z^2)} \ |F(z)|^2 z^{-1} dz$$

$$= \frac{1}{2\pi j} \oint \frac{z \prod\limits_{i=1}^{m-1} (b_i z^2 - a_i z + 1)}{\prod\limits_{i=1}^{m} (z^2 - a_i z + b_i)}$$

$$\cdot \ \frac{(1+R_n z) \prod\limits_{i=1}^{n-1} (b_i - a_i z + z^2)}{\prod\limits_{i-1}^{n} (1 - a_i z + b_i z^2)} \ |F(z)|^2 z^{-1} dz$$

$$= \frac{1}{2\pi j} \oint \frac{z (1+R_n z) \prod\limits_{i=n+1}^{m-1} (b_i z^2 - a_i z + 1)}{\prod\limits_{i=n}^{m} (z^2 - a_i z + b_i)} \ |F(z)|^2 z^{-1} dz$$

$$= \frac{1}{2\pi j} \oint \frac{|F(z)|^2}{(z^2 - a_n z + b_n)(z^2 - a_m z + b_m)}$$

5

$$\cdot \; \frac{\displaystyle\prod_{i=n+1}^{m-1}(b_i z^2 - a_i z + 1)}{\displaystyle\prod_{i=n+1}^{m-1}(z^2 - a_i z + b_i)} \cdot (1 + R_n z) \, dz$$

$$= \frac{1}{2\pi j} \oint \frac{|F(z)|}{z^2 - a_n z + b_n} \cdot \frac{|F(z)|}{z^2 - a_m z + b_m}$$

$$\cdot \; \frac{\displaystyle\prod_{i=n+1}^{m-1}(b_i z^2 - a_i z + 1)}{\displaystyle\prod_{i=n+1}^{m-1}(z^2 - a_i z + b_i)} \cdot (1 + R_n z) \, dz \; \cdot$$

$$(2)$$

The term

$$\frac{\displaystyle\prod_{i=n+1}^{m-1}(b_i z^2 - a_i z + 1)}{\displaystyle\prod_{i=n+1}^{m-1}(z^2 - a_i z + b_i)}$$

in Equ. (2) describes an all-pass filter circuit. If $f_n(z) = z^2 - a_n z + b_n$ and $f_m(z) = z^2 - a_m z + b_m$, and $a_n$, $a_m$, $b_n$, and $b_m$ are selected so that the roots of $f_n(z)$ and $f_m(z)$ are located near the unit circle, then:

$$\frac{|F(z)|}{z^2 - a_n z + b_n} = \frac{|F(z)|}{(z - p_n)(z - \bar{p}_n)}$$

$$= \frac{|F(z)|}{\bar{p}_n - p_n} \cdot \left( \frac{1}{z - \bar{p}_n} - \frac{1}{z - p_n} \right) \approx \frac{1}{\bar{p}_n - p_n} \left\{ \frac{|F(\bar{p}_n)|}{z - \bar{p}_n} - \frac{|F(p_n)|}{z - p_n} \right\} \cdot$$

$$= \frac{1}{\overline{p}_n - p_n} \left\{ \frac{z|F(\overline{p}_n)| - |F(\overline{p}_n)| - z|F(p_n)| + \overline{p}_n|F(p_n)|}{(z - \overline{p}_n)(z - p_n)} \right\}$$

$$= \frac{1}{\overline{p}_n - p_n} \cdot \frac{|F(p_n)|(\overline{p}_n - p_n)}{(z - \overline{p}_n)(z - p_n)} = \frac{|F(p_n)|}{z^2 - a_i z + b_i} \tag{3}$$

$$\left( \because |F(\overline{p}_n)| = |\overline{F(p_n)}| = |F(p_n)| \right)$$

and similarly:

$$\frac{|F(z)|}{z^2 - a_m z + b_m} \approx \frac{|F(p_m)|}{z^2 - a_m z + b_m} \tag{4}$$

where an overbar indicates the complex conjugate.

From equations (2) to (4) it follows that:

$$E[g_m(k) \cdot v_n(k)]$$

$$\approx \frac{1}{2\pi j} |F(p_n)| |F(p_m)| \oint \frac{1}{z^2 - a_n z + b_n} \cdot \frac{1}{z^2 - a_m z + b_m}$$

$$\cdot \frac{\displaystyle\prod_{i=n+1}^{m-1} (z^2 - a_i z + b_i)}{\displaystyle\prod_{i=n+1}^{m-1} (z^2 - a_i z + b_i)} (1 + R_n z) dz \tag{5}$$

Since the integrand in Eq. (5) matches the case of $|F(z)| = 1$. which is the case of white noise input to the adaptive digital filter, the contour integral is zero. Therefore:

$$E[g_m(k) \cdot v_n(k)] \approx 0 \tag{6}$$

The other orthogonality conditions are also approximately satisfied; that is, $E[g_m(k) \cdot v_m(k)]$, $E[g_m(k) \cdot g_n(k)]$ and $E[v_m(k) \cdot v_n(k)]$ can be shown to be approximately zero. Thus if the poles of the second-order recursive digital filter are near the unit circle in the z-plane, $u_m(k)$ and $u_m(k-1)$ are approximately orthogonal even when the input signal is non-white.

Figure 5 shows the m-th basic section (m = 1 to M-1) in Figure 3 modified by the addition of a variable-coefficient scaler $A_m(k)$ with variable coefficeint $A_m(k)$ and a variable-coefficient scaler $B_m(k)$ with variable coefficient $B_m(k)$. (Similar modifications are also made to the M-th basic section). The purpose of the variable scaler coefficients $A_m(k)$ and $B_m(k)$ is to equalize the mean square values of the input signals to the scaler $c_m(k)$ with variable scaler coefficient $c_m(k)$ and the scaler $d_m(k)$ with variable scaler coefficient $d_m(k)$.

$A_m(k)$ and $B_m(k)$ are accordingly selected as follows:

$$A_m(k) = \frac{1}{\sqrt{\dfrac{1}{N=1}\sum_{j=0}^{N} v_m{}^2 (k-j)}}$$

$$B_m(k) = \frac{1}{\sqrt{\dfrac{1}{N+1}\sum_{j=0}^{N} g_m{}^2 (k-j)}} \tag{7}$$

If the well-known learning identification algorithm is used for updating the values of $c_m(k)$ and $d_m(k)$, then:

$$c_m(k+1) = c_m(k) + \frac{\alpha\; e(k).A_m(k).v_m(k)}{\sum\limits_{m=1}^{M} [\{A_m{}^2(k).v_m{}^2(k)\}+\{B_m{}^2(k).g_m{}^2(k)\}]}$$

$$\alpha \;:\; \text{Loop gain (constant)} \tag{8}$$

Combining the scalers $A_m(k)$ and $C_m(k)$ so that $C_m(k) = A_m(k)\, c_m(k)$, Eq. (8) becomes:

$$C_m(k+1) = C_m(k) + \frac{\alpha\; e(k).A_m{}^2(k).v_m(k)}{\sum\limits_{m=1}^{M} [\{A_m{}^2(k).v_m{}^2(k)\}+\{B_m{}^2(k).g_m{}^2(k)\}]}$$

$$\tag{9}$$

Let:

$$\xi_m(k) = \sum_{j=0}^{N} v_m{}^2(k-j), \quad \emptyset_m(k) = \sum_{j=0}^{N} g_m{}^2(k-j) \tag{10}$$

Then from Eqs. (7) and (9):

$$C_m(k+1) = C_m(k) + \frac{\alpha\; e(k).\dfrac{v_m(k)}{\xi_m(k)}}{\sum\limits_{m=1}^{M} \left\{\dfrac{v_m{}^2(k)}{\xi_m(k)} + \dfrac{g_m{}^2(k)}{\emptyset_m(k)}\right\}} \tag{11}$$

Similarly:

$$d_m(k+1) = d_m(k) + \frac{\alpha \; e(k) \cdot B_m(k) \cdot g_m(k)}{\displaystyle\sum_{m=1}^{M} [\{A_m^2(k) \cdot v_m^2(k)\} + \{B_m^2(k) \cdot g_m(k)\}]} \qquad (12)$$

If we set $D_m(k) = B_m(k)$, then from Eqs. (10) and (12):

$$D_m(k+1) = D_m(k) + \frac{\alpha \cdot e(k) \cdot \dfrac{g_m(k)}{\emptyset_m(k)}}{\displaystyle\sum_{m=1}^{M} \dfrac{v_m^2(k)}{\xi_m(k)} + \dfrac{g_m^2(k)}{\emptyset_m(k)}} \qquad (13)$$

If $f_m(z) = z^2 - a_m z + b_m$ and $a_m$ and $b_m$ are selected so that the roots (poles) of $f_m(z)$ are located near the unit circle, and the variable scaler coefficients $C_m$ and $D_m$ are updated by Eqs. (11) and (13), the signals $g_m(k)$ and $v_m(k)$ will be nearly orthogonal and their mean square values will all be equal; therefore the rate of convergence of the adaptive parameters will be extremely fast.

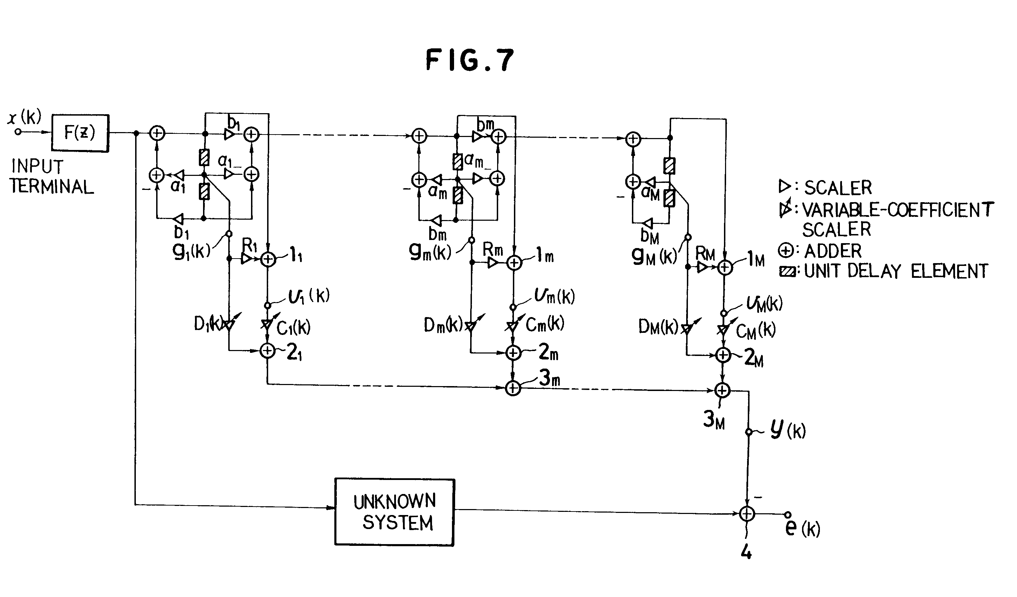

Figure 7 shows a first embodiment based on the principles above. The adaptive digital filter used in this embodiment comprises M basic sections connected in series (where M is a positive integer). The first M-1 basic sections (from 1 to M - 1) each comprise a second-order recursive digital filter and a second-order non-recursive digital filter. The final basic section (M) comprises a second-order recursive digital filter. The output of the second-order non-recursive digital filter is connected to the input of the second-order recursive digital filter in the next section. In addition, the m-th basic section (m = 1 to M) comprises a scaler $R_m$ for multiplying the first-order delayed output $g_m(k)$ by a scaler coefficient $R_m$, a first adder $1_m$ for adding the output of the scaler $R_m$ to the Oth-order delayed output signal, a first variable-coefficient scaler $C_m(k)$ for multiplying the output $v_m(k)$ of the first adder $1_m$ by a variable scaler coefficient $C_m(k)$, second variable-coefficient scaler $D_m(k)$ for multiplying the first-order delayed output $g_m(k)$ by a variable coefficient $D_m(k)$, and a second adder $2_m$ for adding the output of the first variable-coefficient scaler to the output of the second variable-coefficient scaler. An adder $3_m$ adds the output of the second adder $2_m$ to the output of the second adder $2_{m+1}$ in the next section, and this process continues through the adder $3_M$, from which is obtained the final output y(k) of the filter.

The scaler coefficents $a_m$ and $b_m$ are selected as described above. Specifically, they are determined as follows. If $a_m$ and $b_m$ are selected so that:

$$\prod_{m=1}^{M} (z^2 - A_m z = b_m) = z^{2M} \pm R \; (R = \prod_{m=1}^{M} b_m) \qquad (14)$$

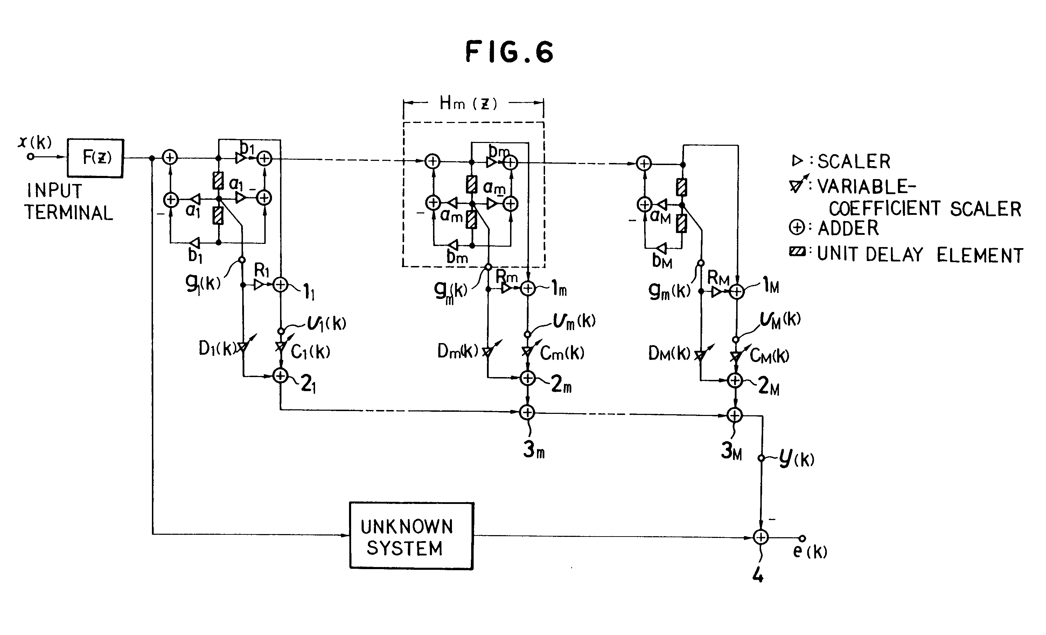

then the transfer function H(z) of the adaptive digital filter in Figure 6 will be:

$$H(z) = \frac{N(z)}{1 \pm R z^{-2M}} \qquad (15)$$

where N(z) is a function of $C_m$ and $D_m$. If $R \ll 1$, then $H(Z) \approx N(z)$, so that the unknown system can be estimated to be N(z). Let $re^{j\theta k}$ be a root of $(z^{2M} \pm R)$. Since $r^{2M}e^{j2M\theta k} + R = 0$:

$$r^{2M}e^{j2M\theta k} = -R = Re^{j\pi}\cdot e^{j2\pi k} \quad (K=0,1,2 \ldots, 2M-1)$$

hence

$$r = R^{1/2M}, \quad \theta_k = \frac{\pi(1+2k)}{2M} \qquad (16)$$

Similarly, since $r^{2M}e^{j2M\theta k} - R = 0$:

$$r^{2M}e^{j2M\theta k} = R = Re^{j2\pi k} \quad (k=0,1,2\ldots,2M-1)$$

hence

$$r = R^{1/2M}, \quad \theta_k = \frac{\pi\cdot k}{M} \qquad (17)$$

From Eq. (14),

$$z^2 = -a_m z + b_m = (z-re^{j\theta m})(z-re^{-j\theta m})$$

$$= z^2 - 2rz\cos\theta_m + r^2 \qquad (18)$$

hence

$$a_m = 2r\cos\theta_m = 2R^{1/2M}\cdot\cos\theta_m, \quad b_m = R^{1/M} = r^2 \qquad (19)$$

$$(m=0,1,2,\ldots,M-1) \qquad .$$

with the condition that when $\theta_0 = 0$, $a_m = 0$ and $b_m = -R^{1/M}$ (the real root).

For example, suppose $R = 0.1$ and $2M = 100$. (Values of this order are required in applications such as echo cancelers). From Eqs. (16) and (17) the pole radius is $r = R^{1/2M} = 0.1^{1/100} = 0.9772$, which is close to the unit circle. Eqs. (16) and (17) also indicate that the poles are located at equally-spaced angles at the radius $r = R^{1/2M}$ centered around the origin of the z-plane.

The variable-coefficient scaler scalers $C_m(k)$ and $D_m(k)$ ($m = 1$ to M) are updated according to Eqs (11) and (13) and $a_m$ and $b_m$ are selected according to Eq.(19).

The output signal from $F(z)$, which becomes the input to the first basic section, is added to the output of the second-order recursive digital filter in that section. The sum, which is the 0th-order delayed output, is multiplied by the coefficient $b_1$. The result is added to the output of the second-order non-recursive digital filter and sent to the next section. The first-order delayed output $g_1(k)$ is multiplied by the coefficient $R_1$ and the result is added to the 0th-order delayed signal. The resulting sum $V_1(k)$ is multiplied by the variable $C_1$-(k), the first-order delayed output $g_1(k)$ is multiplied by the variable coefficient $D_1(k)$, and the two products are added. The sum is added to the corresponding sum in the next section. This same process is repeated until the filter ouput $y(k)$ is obtained from the final section M. The output from the unknown system is subtracted from the filter output $y(k)$ in the adder 4 to obtain the residual difference signal (error signal) $e_k$.

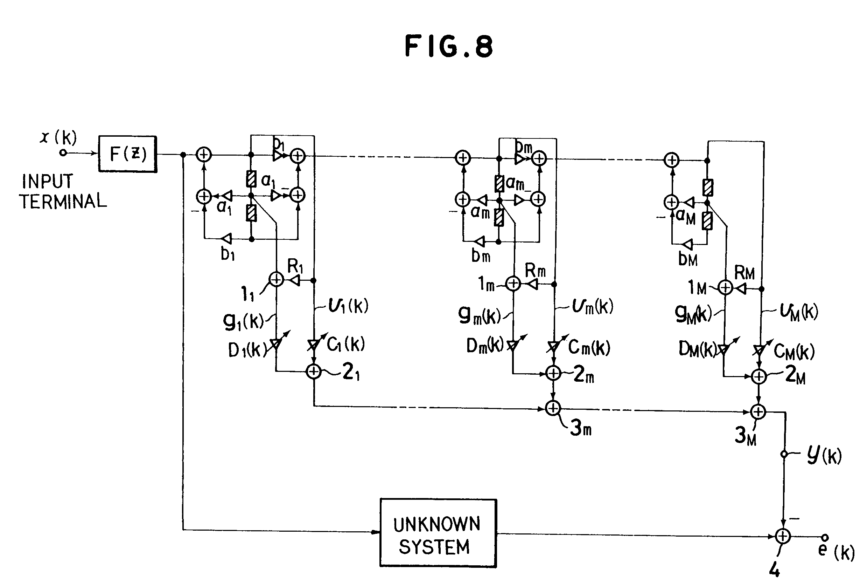

Figure 8, shows the second embodiment. The scalers $R_m$ ($m = 1$ to M) are inserted in a position reverse to that in the embodiment shown in Figure 7. That is, the 0th-order delayed output $v_m(k)$ is multiplied by the coefficient $R_m$, and added to the first-order delayed output in the adder $1_m$. The result $g_m$-(k) is multiplied by the variable coefficient $D_m(k)$. The 0th-order delayed output $v_m(k)$ is also multiplied by the variable coefficient $C_m(k)$. The two product signals are added in the adder $2_m$. Despite this difference in configuration, the adaptive digital filter of the second embodiment functions in the same way as in the first embodiment. Further explanation is therefore omitted here.

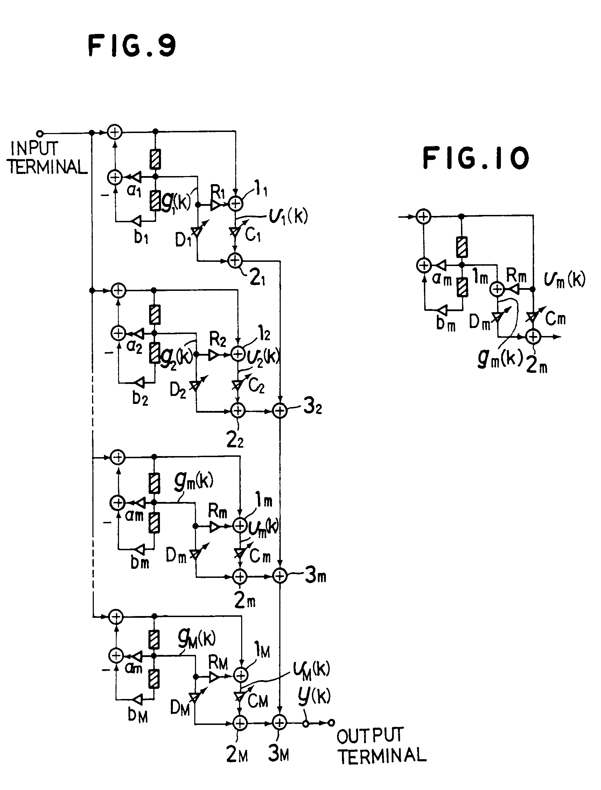

Figure 9 shows a third embodiment comprising M second-order recursive digital filters connected in parallel. Each second-order recursive digital filter comprises a scaler $R_m$ for multiplying the first-order delayed output $g_m(k)$ by a coefficient $R_m$, a first adder $1_m$ for adding the output of the scaler $R_m$ to the 0th-

order delayed output signal, a first variable-coefficient scaler $C_m(k)$ for multiplying the output $v_m(k)$ of the first adder $1_m$ by a variable coefficient $C_m(k)$, a second variable-coefficient scaler D for multiplying the first-order delayed output $g_m(k)$ by a variable coefficient $D_m(k)$, and a second adder $2_m$ for adding the output of the first variable-coefficient scaler to the output of the second variable-coefficient scaler. An adder $2_m$ adds the output of the second adder $2_m$ to the output of the second adder in the previous section $2_m$-1 (not shown in the figure). The final output of the filter is obtained from the adder $3_M$.

The input signal applied to the input terminal is fed to all of the second-order recursive digital filters. This input is added to the value of the first-order delayed output $g_m(k)$ multiplied by the coefficient $a_m$ minus the value of the second-order delayed output multiplied by the coefficient $b_m$. The first-order delayed output $g_m(k)$ is also multiplied by the coefficient $R_m$ and added to the 0th-order delayed output in the adder $1_m$. The output $v_m(k)$ of this adder $1_m$ is multiplied by the variable coefficient $C_m$. The first-order delayed output $g_m(k)$ is also multiplied by variable coefficient $D_m$. The two product signals are added in the adder $2_m$, and the sum is output to the adder $3_m$. The adder $3_m$ adds the output of the adder $2_m$ to the corresponding output in the preceding section and feeds the result to the corresponding adder $3_{m+1}$) in the next section. The final output of the filter is obtained from the adder $3_M$.

$a_m$ and $b_m$ (m = 1 to M) are selected so that the input signals to the variable-coefficient scaler $C_m(k)$ and $D_m(k)$ are approximately orthogonal, and their mean square values are all equalized by the variable-coefficient scaler $C_m(k)$ and $D_m(k)$.

Figure 10 shows one basic section of the fourth embodiment of the invention. In this embodiment, the scalers $R_m$ (m = 1 to M) are inserted in positions reverse to those in the embodiment shown in Figure 9. That is, the 0th-order delayed output $v_m(k)$ is multiplied by the coefficient $R_m$, then added to the first-order delayed output in the adder $1_m$. The result $g_m(k)$ is multiplied by the variable coefficient $D_m$. The 0th-order delayed output $v_m(k)$ is also multiplied by the variable coefficient $C_m(k)$. The two product signals are added in the adder $2_m$, and the result is added to the corresponding output from the preceding section. The other parts of the embodiment in Figure 10 function in the same way as in the embodiment of Figure 9 and produce the same result. Further explanation is therefore omitted here.

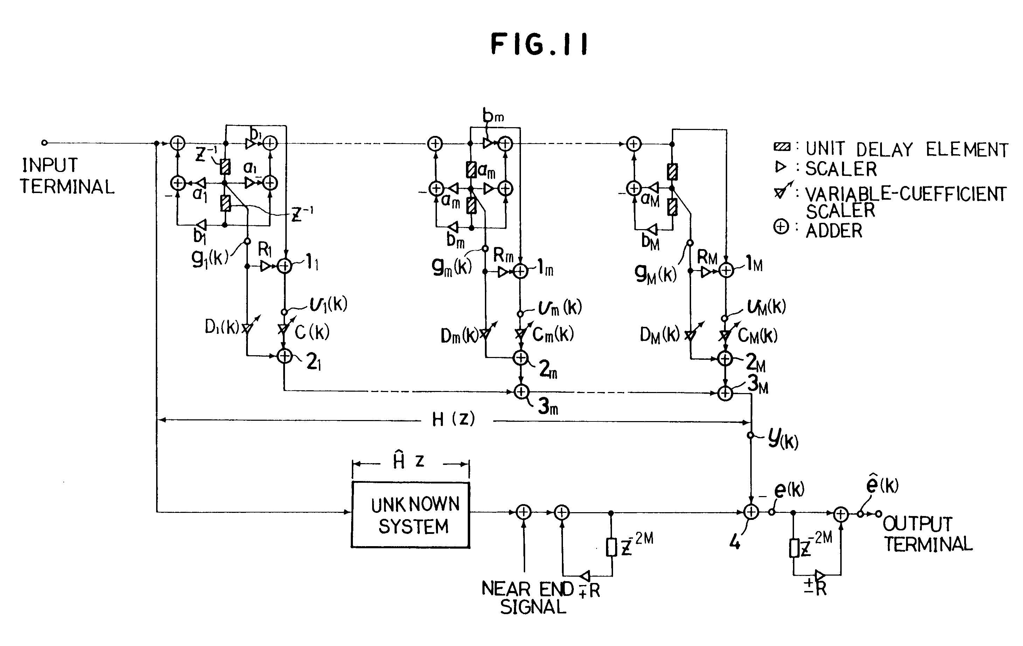

A fifth embodiment of the invention is shown in Figure 11. This embodiment is an echo canceler having an adaptive digital filter similar to the embodiment of Figure 9 but also includes a measure providing for the case in which the R in the denominator polynomial $1 \pm Rz^{-2M}$ in Eq. (15) cannot be ignored. The adaptive digital filter with the transfer function H(z) in this figure is identical to the adaptive digital filter in Figure 6. From Eq. (15) the transfer function H(z) of this adaptive digital filter is:

$$H(z) = \frac{N(z)}{1 \pm Rz^{-2M}}$$

A recursive digital filter having a transfer function of $1/(1 \pm Rz^{-2M})$ is inserted in series with the unknown system H(z), so:

$$\frac{N(z)}{1 \pm Rz^{2M}} = \frac{\hat{H}(z)}{1 \pm Rz^{-2M}} \tag{20}$$

from which it follows that $N(z) = \hat{H}(z)$, indicating that N(z) is capable of accurately estimating $\hat{H}(z)$. When the adaptive digital filter in this drawing is used in a bidirectional communiction system as shown in Figure 2, since a non-recursive digital filter with the inverse transfer function of $1/(1 \pm Rz^{-2M})$ is connected to the output of the adder 4, the transfer function from the signal input point at the microphone to the output terminal (leading to the communication line) is:

$$\frac{1}{1 \pm Rz^{-2M}} \cdot (1 \pm Rz^{-2M}) = 1 \tag{21}$$

Hence the signal input at the microphone is reproduced at the output terminal.

Let E(z) be the z-transform of e(k) in the drawing and let $\hat{E}(z)$ be the z-transform of $\hat{e}(k)$. Then:

$$E(z) = \frac{\hat{H}(z) - N(z)}{1 \pm Rz^{-2M}} \qquad (22)$$

$$\hat{E}(z) = E(z) \cdot (1 + Rz^{-2M}) = \hat{H}(z) - N(z) \qquad (23)$$

The error signal $\hat{H}(z) - N(z)$ is produced at the output terminal, but this quantity is not in question because it is the estimation error.

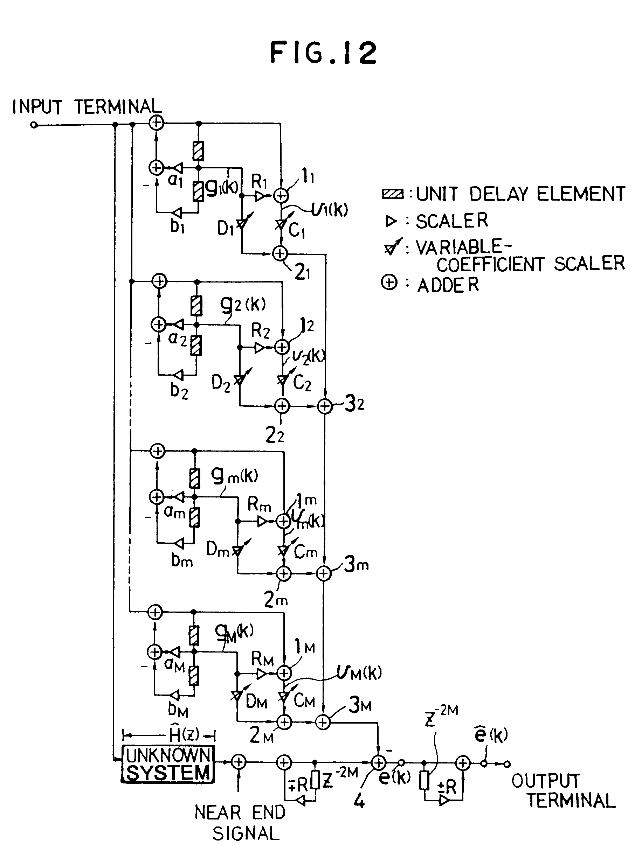

The measure providing for the case in which the R in the denominator polynominal $1 \pm Rz^{-2M}$ in Eq. (15) cannot be ignored, as described in connection with the embodiment of Fig. 11 can be adopted to any of the embodiments of Figs. 8 to 10 as well. Figure 12 shows the configuration where such measure is adopted to the embodiment of Figure 9. The functions are similar to those described in connection with the embodiment of Figure 11.

## Claims

1. An adaptive digital filter (ADF) comprising M basic sections (where M is a positive integer) each having a second-order recursive filter with scaler coefficients $a_m$ and $b_m$, a first coefficient scaler for multiplying a first one of a zeroth-order delayed output ($v_m(k)$) and a first-order delayed output ($g_m(k)$) from the second-order recursive filter by a first coefficient ($R_m$), a first variable-coefficient scaler for multiplying the first one of the zeroth-order delayed output ($v_m(k)$) and the first-order delayed output ($g_m(k)$) from the second-order filter by a first variable coefficient ($D_m(k),C_m(k)$), a first adder ($1_m$) for adding the output from the first scaler and a second one of the zeroth-order delayed output ($v_m(k)$) and the first-order delayed output ($g_m(k)$) from the second-order recursive filter, a second variable-coefficient scaler for multiplying the output from the first adder by a second variable coefficient ($C_m(k)$, $D_m(k)$) and a second adder ($2_m$) for adding the outputs from each of the variable coefficient scalers, characterised in that the scaler coefficients $a_m$ and $b_m$ are selected such that the poles of the second order recursive filter are located near the unit circle in the Z plane, and the first variable-coefficient ($D_m(k),C_m(k)$) and the second variable-coefficient ($C_m(k),D_m(k)$) are selected such that the mean square values of the first one of the zeroth-order delayed output ($v_m(k)$) and the first-order delayed output ($g_m(k)$) from the second-order recursive filter and the output from the first adder ($1_m$) are equal.

2. An adaptive digital filter (ADF) according to claim 1 wherein the first one of the outputs from the second-order recursive filter is a first-order delayed output ($g_m(k)$) and the second one of the outputs from the second-order recursive filter is a zeroth-order delayed output ($v_m(k)$).

3. An adaptive digital filter according to claim 1 wherein the first one of the outputs from the second-order recursive filter is a zeroth-order delayed output ($v_m(k)$) and the second one of the outputs from the second-order recursive filter is a first-order delayed output ($g_m(k)$).

4. An adaptive digital filter of claim 2 or claim 3 wherein the M basic sections are connected in series.

5. An adaptive digital filter according to claim 4 wherein M-1 of the M basic sections has a second-order non-recursive filter, the output of which is connected to the second-order recursive filter of the next section.

6. An adaptive digital filter according to claim 2 or claim 3 wherein the M basic sections are connected in parallel.

7. An adaptive digital filter according to claim 5 or claim 6 wherein the outputs from the second adder ($2_m$) of each section are added to produce the final output from the filter.

8. An echo canceler incorporating the adapative digital filter according to any of claims 1 to 7.

## Revendications

12

1. Filtre numérique adaptatif (ADF) comportant M sections de base (M étant un entier positif), chaque section disposant d'un filtre récursif de deuxième ordre avec des coefficients démultiplicateurs $a_m$ et $b_m$, un démultiplicateur à premier coefficient pour multiplier par un premier coefficient ($R_m$) le premier d'un signal de sortie retardé d'ordre zéro ($V_m(k)$) et d'un signal de sortie retardé de premier ordre ($g_m(k)$) provenant du filtre récursif de deuxième ordre, un démultiplicateur à premier coefficient variable pour multiplier par un premier coefficient variable ($D_m(k)$, $C_m(k)$) le premier du signal de sortie d'ordre zéro ($V_m(k)$) et du signal de sortie retardé de premier ordre ($g_m(k)$), un premier additionneur ($1_m$) pour additionner le signal de sortie du premier démultiplicateur et le second du signal de sortie retardé d'ordre zéro ($V_m(k)$) et du signal de sortie retardé de premier ordre ($g_m(k)$) provenant du filtre récursif de deuxième ordre, un démultiplicateur à deuxième coefficient variable pour multiplier le signal de sortie du premier additionneur par un deuxième coefficient variable ($C_m(k)$, $D_m(k)$) et un deuxième additionneur ($2_m$) pour additionner les signaux de sortie de chacun des démultiplicateurs à coefficient variable, caractérisé en ce que les coefficients démultiplicateurs $a_m$ et $b_m$ sont choisis de manière que les pôles du filtre de deuxième ordre soient situés à proximité du cercle unité dans le plan Z, et en ce que le premier coefficient variable ($D_m(k)$, $C_m(k)$) et le deuxième coefficient variable ($C_m(k)$, $D_m(k)$) sont choisis de manière que les valeurs quadratiques moyennes du premier du signal de sortie retardé d'ordre zéro ($V_m(k)$) et du signal de sortie retardé de premier ordre ($g_m(k)$) provenant du filtre récursif de deuxième ordre ainsi que du signal de sortie du premier additionneur ($1_m$) soient égales.

2. Filtre numérique adaptatif (ADF) selon la revendication 1, dans lequel le premier des signaux de sortie du filtre récursif de deuxième ordre est un signal de sortie retardé de premier ordre ($g_m(k)$) et le second des signaux de sortie du filtre récursif de deuxième ordre est un signal de sortie retardé d'ordre zéro ($V_m(k)$).

3. Filtre numérique adaptatif selon la revendication 1, dans lequel le premier des signaux de sortie du filtre récursif de deuxième ordre est un signal de sortie retardé d'ordre zéro et le second des signaux de sortie du filtre récursif de deuxième ordre est un signal de sortie retardé de premier ordre ($g_m(k)$).

4. Filtre numérique adaptatif selon la revendication 2 ou la revendication 3, dans lequel les M sections de base sont branchées en série.

5. Filtre numérique adaptatif selon la revendication 4, dans lequel M-1 des M sections de base ont un filtre non récursif de deuxième ordre dont la sortie est raccordée au filtre récursif de deuxième ordre de la section suivante.

6. Filtre numérique adaptatif selon la revendication 2 ou la revendication 3, dans lequel les M sections de base sont branchées en parallèle.

7. Filtre numérique adaptatif selon la revendicaiton 5 ou la revendication 6, dans lequel les signaux de sortie du deuxième additionneur de chaque section sont additionnés pour produire le signal de sortie final du filtre.

8. Annuleur d'écho comportant le filtre numérique adaptatif selon l'une quelconque des revendications 1 à 7.

**Patentansprüche**

1. Adaptives Digitalfilter (ADF), das aufweist M Basisabschnitte (wobei M eine positive ganze Zahl ist), von denen jeder umfaßt ein rekursives Filter zweiter Ordnung mit Skaliererkoeffizienten $a_m$ und $b_m$, einen ersten Skaliererkoeffizienten zum Multiplizieren eines ersten von einem verzögerten Ausgang ($v_m(k)$) nullter Ordnung und einem verzögerten Ausgang ($g_m(k)$) erster Ordnung des rekursiven Filters zweiter Ordnung mit einem ersten Koeffizienten ($R_m$), einen ersten Skalierer mit variablem Koeffizienten zum Multiplizieren des ersten von dem verzögerten Ausgang ($v_m(k)$) nullter Ordnung und dem verzögerten Ausgang ($g_m(k)$) erster Ordnung des Filters zweiter Ordnung mit einem ersten variablen Koeffizienten ($D_m(k),C_m(k)$), einen ersten Addierer ($l_m$) zum Addieren des Ausgangs des ersten Skalierers und eines zweiten von dem verzögerten Ausgang ($v_m(k)$) nullter Ordnung und dem verzögerten Ausgang ($g_m(k)$) erster Ordnung des rekursiven Filters zweiter Ordnung, einen zweiten Skalierer mit variablem Koeffizienten zum Multiplizieren des Ausgangs des ersten Addierers mit einem zweiten variablen Koeffizienten ($C_m(k)$, $D_m(k)$) und einen zweiten Addierer ($2_m$) zum Addieren der Ausgänge von jedem der Skalierer mit variablem Koeffizienten, dadurch gekennzeichnet, daß die Skaliererkoeffizienten am und bm so ausgewählt sind, daß die Pole des rekursiven Filters zweiter Ordnung neben dem Einheitskreis in der z-Ebene angeordnet sind und daß der erste variable Koeffizient ($D_m(k)$,$C_m(k)$) und der zweite variable Koeffizient ($C_m(k)$, $D_m(k)$) so ausgewählt sind, daß die quadratischen Mittelwerte des ersten von dem verzögerten Ausgang nullter Ordnung ($v_m(k)$) und dem verzögerten Ausgang erster Ordnung ($g_m(k)$) des rekursiven Filters zweiter Ordnung und der Ausgang des ersten Addierers ($l_m$) gleich sind.

2.  Adaptives Digitalfilter (ADF) nach Anspruch 1, worin der erste von den Ausgängen des rekursiven Filters zweiter Ordnung ein verzögerter Ausgang ($g_m(k)$) erster Ordnung ist und der zweite von den Ausgängen des rekursiven Filters zweiter Ordnung ein verzögerter Ausgang nullter Ordnung ($v_m(k)$) ist.

3.  Adaptives Digitalfilter nach Anspruch 1, worin der erste von den Ausgängen des rekursiven Filters zweiter Ordnung ein verzögerter Ausgang nullter Ordnung ($v_m(k)$) ist und der zweite von den Ausgängen des rekursiven Filters zweiter Ordnung ein verzögerter Ausgang erster Ordnung ($g_m(k)$) ist.

4.  Adaptives Digitalfilter nach Anspruch 2 oder Anspruch 3, worin die M Basisabschnitte in Serie verbunden sind.

5.  Adaptives Digitalfilter nach Anspruch 4, worin M-1 der M Basisabschnitte ein nicht-rekursives Filter zweiter Ordnung haben, dessen Ausgang mit dem rekursiven Filter zweiter Ordnung des nächsten Abschnitts verbunden ist.

6.  Adaptives Digitalfilter nach Anspruch 2 oder Anspruch 3, worin die M Basisabschnitte parallel miteinander verbunden sind.

7.  Adaptives Digitalfilter nach Anspruch 5 oder Anspruch 6, worin die Ausgänge des zweiten Addierers ($2_m$) jedes Abschnittes addiert werden, um den Endausgang des Filters zu erzeugen.

8.  Echoauslöscher, der das adaptive Digitalfilter nach irgendeinem der Ansprüche 1 bis 7 aufweist.

# FIG.1

**13:UNKNOWN SYSTEM**

H (z) $\quad y(k)$

**11:SIGNAL INPUT TERMINAL**

**15:ADDER**

$+$

$e(k)$

$-$

**12:SIGNAL OUTPUT TERMINAL**

**14:ADF**

$\hat{H}$ (z) $\quad \hat{y}(k)$

# FIG.2

**23-1:ECHO CANCELER**

**21-1:MICROPHONE**

**24-1:TRANSMISSION LINE**

**23-2:ECHO CANCELER**

**22-2:LOUDSPEAKER**

$\tilde{y}(k)$

$+$

$-$ $y(k)$

**26-1: ACOUSTIC COUPLING PATH**

ADF $\quad$ 25-1

**24-2: TRANSMISSION LINE**

ADF $\quad$ 25-2

**26-2:ACOUSTIC COUPLING PATH**

$x(k)$

$-$ $+$

**21-2:MICROPHONE**

**22-1:LOUDSPEAKER**

EP 0 274 850 B1

# FIG.3

$\vdash$→BASIC SECTION←$\dashv$

$\triangleright$ : SCALER

$\not\triangleright$ : VARIABLE-COEFFICIENT SCALER

$\oplus$ : ADDER

$\boxtimes$ : UNIT DELAY ELEMENT

EP 0 274 850 B1

# FIG.4

# FIG.5

EP 0 274 850 B1

17

# FIG.6

EP 0 274 850 B1

# FIG.7

$x(k)$

INPUT TERMINAL

$F(z)$

$b_1$

$a_1$

$b_1$

$g_1(k)$   $R_1$   $1_1$

$D_1(k)$   $C_1(k)$

$U_1(k)$

$2_1$

$b_m$

$a_m$

$b_m$

$g_m(k)$   $R_m$   $1_m$

$D_m(k)$   $C_m(k)$

$U_m(k)$

$2_m$

$3_m$

$b_M$

$a_M$

$b_M$

$g_M(k)$   $R_M$   $1_M$

$D_M(k)$   $C_M(k)$

$U_M(k)$

$2_M$

$3_M$   $y(k)$

▷ : SCALER
▷ : VARIABLE-COEFFICIENT SCALER
⊕ : ADDER
▨ : UNIT DELAY ELEMENT

UNKNOWN SYSTEM

$e(k)$

$4$

EP 0 274 850 B1

# FIG.8

# FIG.9

# FIG.10

# FIG.11

- ▨ : UNIT DELAY ELEMENT
- ▷ : SCALER
- ◁ : VARIABLE-CUEFFICIENT SCALER
- ⊕ : ADDER

EP 0 274 850 B1

# FIG.12